(19) Europäisches Patentamt
European Patent Office
Office européen des brevets

(11) EP 1 484 381 A1

(12) **EUROPEAN PATENT APPLICATION**
published in accordance with Art. 158(3) EPC

(43) Date of publication:
**08.12.2004 Bulletin 2004/50**

(21) Application number: **03743043.6**

(22) Date of filing: **27.02.2003**

(51) Int Cl.7: **C09K 11/06**, H05B 33/14, C08F 8/42

(86) International application number:
**PCT/JP2003/002207**

(87) International publication number:
**WO 2003/072681 (04.09.2003 Gazette 2003/36)**

(84) Designated Contracting States:
**AT BE BG CH CY CZ DE DK EE ES FI FR GB GR HU IE IT LI LU MC NL PT SE SI SK TR**
Designated Extension States:
**AL LT LV MK RO**

(30) Priority: **28.02.2002 JP 2002054227**

(71) Applicant: **JSR Corporation**
**Tokyo 104-8410 (JP)**

(72) Inventors:
- **ERIYAMA, Yuichi, JSR Corporation**
  **Chuo-ku, Tokyo 104-8410 (JP)**
- **YASUDA, Hiroyuki, JSR Corporation**
  **Chuo-ku, Tokyo 104-8410 (JP)**
- **SAKAKIBARA, Mitsuhiko, JSR Corporation**
  **Chuo-ku, Tokyo 104-8410 (JP)**

(74) Representative:
**Leson, Thomas Johannes Alois, Dipl.-Ing.**
**Tiedtke-Bühling-Kinne & Partner GbR,**
**TBK-Patent,**
**Bavariaring 4**
**80336 München (DE)**

(54) **PHOSPHORS, PROCESS FOR PRODUCTION THEREOF, PHOSPHORESCENT COMPOSITIONS AND ARTICLES MADE BY USING THE SAME**

(57) Disclosed herein are a phosphorescent agent containing a structural unit represented by the following general formula (1):

EP 1 484 381 A1

General formula (1)

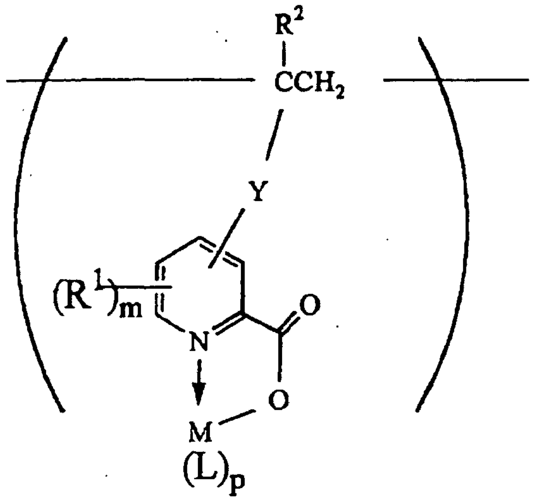

wherein M is a metal atom having a valence of 2 to 4, $R^1$ is a monovalent group selected from a hydrogen atom, halogen atoms, alkyl groups and aryl groups, $R^2$ is a hydrogen atom or methyl group, Y is a single bond or a divalent organic group including a carbonyl group, L is an organic ligand, m is an integer of 1 to 3, and p is an integer of 1 to 4, in its molecule and having a molecular weight of 1,000 to 500,000, production process thereof, and a luminescent composition containing such a compound and applied products thereof.

## Description

### TECHNICAL FIELD

The present invention relates to a phosphorescent agent and a production process thereof, and a luminescent composition and applied products thereof, and particularly to a phosphorescent agent suitably usable as a material for an organic electroluminescence device produced by an ink-jet method and a production process thereof, and a luminescent composition containing this phosphorescent agent and applied products thereof.

### BACKGROUND ART

An organic electroluminescence device (hereinafter also referred to as "organic EL device") is expected to be a display device of the coming generation because it has such excellent properties as can be formed into a thin structure, driven by a direct current voltage, is wide in angle of visibility and high in visibility because it is a self-luminescent device, and fast in speed of response, and the researches thereof are actively conducted.
As such organic EL devices, have been known those of a single-layer structure that a luminescent layer composed of an organic material is formed between an anode and a cathode and those of a multi-layer structure such as those of a structure having a hole-transporting layer between an anode and a luminescent layer and those having an electron-transporting layer between a cathode and a luminescent layer. These organic EL devices all emit light by recombination of an electron injected from the cathode with a hole injected from the anode at the luminescent layer.
In such an organic EL device, as methods of forming an organic material layer such as a luminescent layer or hole-transporting layer, have been known a dry method that the organic material layer is formed by vacuum deposition of organic material and a wet method that the organic material layer is formed by applying a solution with the organic material dissolved therein and drying it. Of these, the dry method is difficult to meet mass production because the process thereof is complicated. In addition, there is a limit to the formation of a layer having a large area. On the contrary, the wet method is advantageous compared with the dry method in that the process is relatively simple, and so the method can meet mass production, and an organic material layer having a large area can be formed with ease and high precision by, for example, an ink-jet method.
On the other hand, the organic material layer making up the organic EL device is required to have high luminance and luminous efficiency. Those composed of various materials have heretofore been known, and an organic material layer containing a phosphorescent organoiridium compound or organoosmium compound as a luminescent molecule has recently been proposed (WO 00/70655). This organic material layer is composed of the low molecular organoiridium compound or organoosmium compound alone or of such a compound and a hole-transporting material such as 4,4'-N,N'-dicarbazole biphenyl or 4,4'-bis[N-(1-naphthyl)-N-phenylamino]biphenyl.
Further, in MRS 2000 Fall Meeting (November 27-December 1, 2000, Boston, Massachusetts, USA), a luminescent material composed of a low-molecular iridium compound, polyvinylcarbazole and oxadiazole has been proposed. However, both materials do not satisfy sufficient performance in luminance and luminous efficiency when a luminescent layer is formed from them by a wet method such as an ink-jet method.

### DISCLOSURE OF THE INVENTION

[Problems to be solved by the Invention]

The present invention has been made on the basis of the foregoing circumstances.
It is the first object of the present invention to provide a phosphorescent agent by which a luminescent layer can be easily formed by a wet method such as an ink-jet method, and an organic electroluminescence device having high luminance can be provided.
The second object of the present invention is to provide a process for producing a phosphorescent agent by which a luminescent layer can be easily formed by a wet method such as an ink-jet method, and an organic electroluminescence device having high luminance can be provided.
The third object of the present invention is to provide a luminescent composition by which an organic electroluminescence device high in both luminance and luminous efficiency is provided.
The fourth object of the present invention is to provide an organic electroluminescence device high in both luminance and luminous efficiency.

[Means for Solving the Problems]

The present inventors have carried out an extensive investigation with a view toward solving the above-described problems. As a result, it has been found that a polymeric metal complex having a specific structural unit has excellent properties as a phosphorescent agent and further has solution properties suitable for the formation of an organic electroluminescence device by a wet method and excellent luminescent properties, thus leading to completion of the present invention.

According to the present invention, there is provided a phosphorescent agent comprising a structural unit represented by the following general formula (1):

General formula (1)

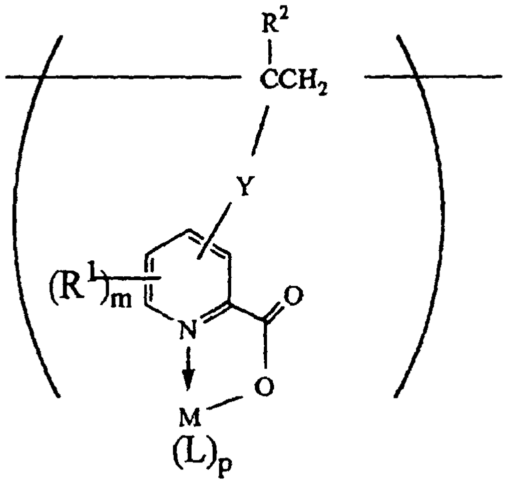

wherein M is a metal atom having a valence of 2 to 4, $R^1$ is a monovalent group selected from a hydrogen atom, halogen atoms, alkyl groups and aryl groups, $R^2$ is a hydrogen atom or methyl group, Y is a single bond or a divalent organic group including a carbonyl group, L is an organic ligand, m is an integer of 1 to 3, and p is an integer of 1 to 4, in its molecule and having a molecular weight of 1,000 to 500,000.

In the phosphorescent agent according to the present invention, at least one of the structural units represented by the general formula (1) contained in the molecule may be such that L indicating the organic ligand in the general formula (1) has an organic ligand represented by the following general formula (2):

General formula (2)

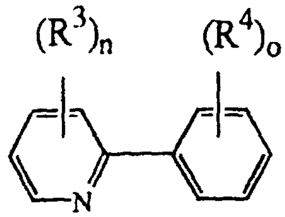

wherein each of $R^3$ and $R^4$ is, independently, a hydrogen atom, halogen atom, alkyl group or aryl group, and each of n and o is, independently, an integer of 1 to 5.

In the phosphorescent agent according to the present invention, M indicating the metal atom in the general formula (1) may be a metal atom selected from the group consisting of Pd, Pt, Rh, Ir, Ru, Os and Re.

The phosphorescent agent according to the present invention may comprise the structural unit represented

by the general formula (1), a structural unit derived from N-vinyl-carbazole and a structural unit derived from vinyl-substituted 1-oxa-3,4-diazole.

According to the present invention, there is provided a process for producing the phosphorescent agent described above, which comprises reacting a picolinic acid structure-containing polymer with a metal complex.

In the production process of the phosphorescent agent according to the present invention, the metal complex may be a metal complex having a metal atom selected from Pd, Pt, Rh, Ir, Ru, Os and Re as a central metal.

According to the present invention, there is provided a luminescent composition comprising the phosphorescent agent described above and an organic solvent.

The luminescent composition according to the present invention may be suitable for use in an organic electroluminescence device.

According to the present invention, there is provided an organic electroluminescence device comprising at least an anode layer, a luminescent layer obtained from a material containing the phosphorescent agent described above and a cathode layer.

The organic electroluminescence device according to the present invention may be obtained by laminating the anode layer, a hole-transporting layer, a copper phthalocyanine layer and the luminescent layer in this order.

The organic electroluminescence device according to the present invention may have a luminescent layer composed of the luminescent composition described above.

According to the present invention, there is provided an organic electroluminescence device obtained through a step of forming a luminescent layer by applying the luminescent composition described above to a surface of a substrate, on which the luminescent layer should be formed, and subjecting the applied composition to a heating treatment.

[Mode for Carrying out the Invention]

The present invention will hereinafter be described in detail.

The phosphorescent agent according to the present invention comprises the structural unit represented by the general formula (1). In the phosphorescent agent, at least one of the structural units represented by the general formula (1) contained in the molecule is preferably such that L indicating the organic ligand in the general formula (1) has an organic ligand represented by the general formula (2).

The structural unit of the general formula (1) is contained at a terminal or in a main chain of a molecule of the phosphorescent agent, and may be contained both at the terminal and in the main chain.

The molecular weight of the phosphorescent agent according to the present invention is 1,000 to 500,000, preferably 1,000 to 100,000, particularly preferably 3,000 to 50,000 as determined as a weight average molecular weight in terms of polystyrene by means of analysis by gel permeation chromatography (hereinafter abbreviated as "GPC").

If the weight average molecular weight is lower than 1,000 or exceeds 500,000, it is not preferable since the coating property of such a phosphorescent agent is deteriorated.

In the general formula (1), M is a metal atom having a valence of 2 to 4. More specifically, M is a metal atom selected from the group consisting of Pd, Pt, Rh, Ir, Ru, Os and Re. Among these metal atoms, Ir, Os and Pt are preferred.

$R^1$ is a monovalent substituent selected from a hydrogen atom, halogen atoms, alkyl groups and aryl groups.

The halogen atoms in $R^1$ include chlorine and fluorine atoms and alkyl groups.

The alkyl groups in $R^1$ include linear, branched or cyclic hydrocarbon groups having 1 to 12 carbon atoms.

The aryl groups in $R^1$ include aromatic rings having 4 to 14 carbon atoms and monovalent organic groups derived from hetero-atom-containing unsaturated cyclic compounds.

$R^2$ is a hydrogen atom or methyl group.

Y is a single bond or a divalent organic group including a carbonyl group, and L is an organic ligand.

m is an integer of 1 to 3, and p is an integer of 1 to 4. These m and p are each selected in such a manner that it satisfies a stable coordination number in the relation with the valence of the metal atom M, and the structural unit of the general formula (1) has a neutral complex structure.

With respect to the relationship between the valence of the metal atom M and the number p of the organic ligands L, the number of outermost shell electrons in the metal atom is selected so as to amount to 16 or 18.

As specific examples of the alkyl groups, may be mentioned methyl, ethyl, propyl, butyl, hexyl, octyl and dodecyl groups.

As specific examples of the aryl groups, may be mentioned phenyl, naphthyl, anthracenyl and biphenyl groups.

As specific examples of the hetero-atom-containing unsaturated cyclic compounds, may be mentioned thiophene, pyrrole, furan, pyridine, pyrimidine, triazine, oxazole and oxadiazole.

L is an organic ligand and selected from organic compounds having coordination property to the metal atom

M. L is preferably suitably selected from phenylpyridine derivatives that are ortho-metallation type ligands represented by the general formula (2).

In the general formula (2), each of $R^3$ and $R^4$ is, independently, a hydrogen atom, halogen atom or a group selected from alkyl groups aryl groups, and $R^3$ and $R^4$ may be the same or different from each other.

Each of n and o is, independently, an integer of 1 to 5 and selected in such a manner that the structural unit of the general formula (1) has a neutral complex structure satisfying the valence of the metal atom M and the stable coordination number.

As specific examples of the organic ligand, may be mentioned monodentate organic ligands such as trialkylamines, triarylamines, pyridine, quinoline, oxazole, trialkylphosphines and triarylphosphines, monovalent organic ligands, such as alkoxides such as methoxides, t-butoxides and phenoxides, and carboxylates such as acetates and trifluoroacetates, didentate or still higher organic ligands, such as acetylacetone, hexafluoroacetylacetone, β-diketones such as 5,5-dimethyl-2,4-hexadione, diamines such as ethylenediamine and dipyridyl, 9-hydroxyquinoline, picolinic acid, and salicylic acid, and phenylpyridine derivatives having a structural unit of the general formula (2).

These organic ligands may be used either singly or in any combination thereof.

Among these organic ligands, the phenylpyridine derivatives tend to cause dehydration by a reaction of a hydrogen atom located at an ortho-position to the bonding site with the pyridine ring on the phenyl group with a metal atom. As a result, they act as an ortho-metallation type chelating agent that the carbon atom at the ortho-position on the phenyl group is connected with the metal atom by a σ-bond to coordinate, and at the same time, the nitrogen atom on the pyridine ring is coordinated with the metal atom. Therefore, they are preferably introduced for the purpose of stabilizing the resulting phosphorescent agent and at the same time, controlling wavelength and intensity of phosphorescence.

As specific examples of the phenylpyridine derivatives, may be mentioned 2-phenylpyridine, 2-biphenylpyridine, 2-(2,6-dimethylphenyl)phenylpyridine, 2-phenyl-4-(N,N-dimethylamino)pyridine, 2-phenyl-4-pyrrolidinopyridine, 2-phenyl-4-(N,N-diphenylamino)pyridine, phenyl-4-methylpyridine, 2-phenyl-4,6-dimethylpyridine, 2-(2-fluorophenyl) pyridine, 2-(2,4-difluorophenyl)pyridine, 2-(2,3,4-trifluorophenyl)pyridine, 2-(2,3,4,5-tetrafluorophenyl)pyridine, 2-phenyl-4-methylpyridine, 2-(2-fluorophenyl)-4-methylpyridine, 2-(2,4-difluorophenyl)-4-methylpyridine, 2-(2,3,4-trifluorophenyl)-4-methylpyridine, 2-(2-naphthyl)pyridine, 2-phenylquinoline, 2-benzoylpyridine, 7,8-benzoquinoline, 9-anthranylpyridine, 2-(2-fluorenyl)pyridine, 2-(2-(9,10-dimethyl)fluorenyl)pyridine, 2-(2-(9,10-dihexyl)fluorenyl)pyridine and 2-(2-(9,10-dioctyl)fluorenyl)pyridine.

In such a phosphorescent agent, a peak wavelength of phosphorescence falls within a range of 440 to 700 nm.

Here, as an organic EL device, is preferably used that whose luminescence wavelength falls within the same range of 440 to 700 nm which is the same range as that of the phosphorescence peak wavelength of the phosphorescent agent according to the present invention.

The phosphorescent agent according to the present invention is produced through a process of 2 steps.

In the process of the first step, an unsaturated picolinic acid derivative is homopolymerized or copolymerized with a copolymerizable component composed of another unsaturated compound in the presence of a radical polymerization initiator and an organic solvent under an inert gas atmosphere, thereby preparing a polymer (hereinafter also referred to as "picolinic acid-containing polymer") composed of a picolinic acid-containing polymer containing a structural unit derived from an unsaturated picolinic acid derivative.

The content of the structural unit derived from the unsaturated picolinic acid derivative in the picolinic acid-containing polymer is 0.1 to 100 mol%, preferably 1 to 50 mol%, more preferably 3 to 10 mol% based on 100 mol of the whole structure unit.

In the process of the second step, the picolinic acid-containing polymer obtained in the first step is reacted with a metal complex, thereby producing a phosphorescent agent containing the structural unit of the general formula (1) in its molecule.

As the picolinic acid derivative, may be used a vinyl group-containing compound represented by the following general formula (3):

General formula (3)

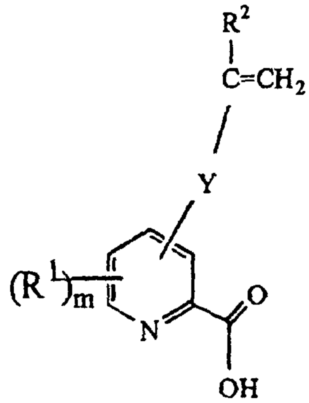

wherein $R^1$ is a monovalent group selected from a hydrogen atom, halogen atoms, alkyl groups and aryl groups, $R^2$ is a hydrogen atom or methyl group, Y is a single bond or a divalent organic group including a carbonyl group, and m is an integer of 1 to 3.

As specific examples of the vinyl group-containing compound represented by the general formula (3), may be mentioned 3-vinylpicolinic acid, 4-vinylpicolinic acid, 5-vinylpicolinic acid, 3-vinyl-4-methylpicolinic acid, 3-vinyl-4,6-dimethylpicolinic acid, 3-methacryloxypicolinic acid, 3-styrylpicolinic acid and 3-(p-vinylphenylmethoxy)picolinic acid.

As examples of the copolymerizable component, may be mentioned acrylic esters, methacrylic esters, styrenes, vinylcarbazoles and styryloxadiazoles.

As specific examples of the copolymerizable component, may be mentioned methyl acrylate, ethyl acrylate, butyl acrylate, phenyl acrylate, biphenyl acrylate, methyl methacrylate, ethyl methacrylate, butyl methacrylate, phenyl methacrylate, octyl methacrylate, cyclohexyl methacrylate, styrene, α-methylstyrene, vinylnaphthalene, vinylbiphenyl, vinylanthracene, vinylcarbazole, 2-styryl-5-phenyl-1-oxa-3,4-diazole, 2-styrylphenyl-5-phenyl-1-oxa-3,4-diazole, 2-styryl-5-phenyl-1-oxa-3,4-diazole and 2-(p-styrylphenyl-5-(p-t-butylphenyl)-1-oxa-3,4-diazole. Among these, styrenes, vinylcarbazoles and styryloxadiazoles are preferably used.

The reaction in the second step comprises mixing the picolinic acid-containing polymer with a metal complex of a metal atom M (M is a metal atom having a valence of 2 to 4) in an organic solvent under an inert gas atmosphere and then subjecting the resultant mixture to a reaction under heat in a temperature range of 50 to 300°C for 1 to 12 hours.

By this reaction, a site related to the picolinic acid in the picolinic acid-containing polymer obtained in the process of the first step reacts with the metal complex, thereby obtaining the phosphorescent agent according to the present invention.

In these reaction systems, nitrogen gas, argon gas or the like is used as the inert gas, and an organic compound having a boiling point of 50 to 300°C under atmospheric pressure is used as the organic solvent.

As specific examples of the organic solvent, may be mentioned alcohols such as butanol, octanol, ethylene glycol, propylene glycol, ethylene glycol monomethyl ether, propylene glycol monomethyl ether, ethylene glycol monoethyl ether, propylene glycol monoethyl ether, ethylene glycol monobutyl ether and propylene glycol monobutyl ether, aromatic hydrocarbons such as toluene, xylene and mesitylene, esters such as ethyl acetate, butyl acetate, ethoxypropylene glycol acetate and γ-butyrolactone, amides such as N-methylpyrrolidone, formamide, dimethylformamide and dimethylacetamide, ethers such as ethylene glycol dimethyl ether, diethylene glycol dimethyl ether, tetrahydrofuran and 1,4-dioxane, and ketones such as cyclohexanone, methyl amyl ketone and methyl isobutyl ketone.

The organic solvent is suitably selected from among the above-mentioned solvents on the basis of the solubility of the polymer. However, the aromatic hydrocarbons, amides, ethers and ketones are preferably used.

As the metal complex, is used a low-molecular metal complex having a metal atom selected from Pd, Pt, Rh, Ir, Ru, Os and Re as a central metal. A low-molecular metal complex the central metal of which is Ir, Os or Pt is preferably used.

As such metal complexes, may be mentioned mononuclear complexes or polynuclear complexes represented by the following general formula (4):

General formula (4)

$$M_x(L)_y(Q)_z$$

wherein M is a metal atom having a valence of 2 to 4, L is an organic ligand, Q is a ligand, the whole or part of which is left by the reaction with the picolinic acid-containing polymer, x is an integer of 1 to 4, and each of y and z is, independently, an integer of 0 to 8.

In the general formula (4), M is a metal atom having a valence of 2 to 4. Specifically, M is selected from Pd, Pt, Rh, Ir, Ru, Os and Re.

L is an organic ligand similar to the general formula (1) and selected from organic compounds having coordination property to the metal atom M.

Q is a ligand, the whole or part of which is left by the reaction with the picolinic acid-containing polymer. Specifically, Q is selected from monovalent or still higher ligands such as halogen atoms, a hydrogen atom, alkoxide groups, alkyl groups, an acetylacetonate group and a carbonyl group.

x is an integer of 1 to 4, and each of y and z is, independently of each other, an integer of 0 to 8.

The process for producing the phosphorescent agent according to the present invention is not limited to the process described above. For example, there may be used a technique that the unsaturated picolinic acid derivative is reacted with the metal complex in advance, thereby synthesizing a metal complex having the unsaturated picolinic acid derivative as a ligand, and this product is radical-polymerized or copolymerized with the copolymerizable component.

Such a phosphorescent agent may preferably have a structural unit derived from N-vinylcarbazole and a structural unit derived from vinyl-substituted 1-oxa-3,4-diazole together with the structural unit represented by the general formula (1).

The luminescent composition according to the present invention is a composition comprising the phosphorescent agent described above and an organic solvent and is suitable for use in an organic electroluminescence device.

As the organic solvent, may be used an organic solvent usable in the production of the phosphorescent agent according to the present invention.

As preferable examples of the organic solvent making up the luminescent composition according to the present invention, may be mentioned ethyl lactate, propylene glycol monomethyl ether, propylene glycol monomethyl acetate and cyclohexane.

The luminescent composition according to the present invention comprises the phosphorescent agent and organic solvent as essential components. In order to control properties such as coating property, luminescence hue and adhesiveness, however, a hole-transporting compound such as an aromatic amine or carbazole compound, an electron-transporting compound such as an oxadiazole compound or an aluminum complex of hydroxyquinoline and a copolymer of the hole-transporting and electron-transporting compounds may be added in addition to these essential components.

The organic electroluminescence device that is a one of the applied product according to the present invention will hereinafter be described.

Fig. 1 is a cross-sectional view illustrating the construction of the organic electroluminescence device according to the present invention.

In this EL device, an anode layer 2 is provided on a transparent substrate 1. A hole-transporting layer 3 is provided on this anode layer 2. A copper phthalocyanine layer 4 is further provided on the hole-transporting layer 3. A luminescent layer 5 is provided on the copper phthalocyanine layer 4, and an electron-injecting layer 6 is provided on the luminescent layer 5. A cathode layer 7 is provided on this electron-injecting layer 6. This cathode layer 7 is also called an electron-injecting electrode layer. The anode layer 2 and the cathode layer 7 are connected to a DC power source 10.

As the transparent substrate 1, may be used a glass substrate, transparent resin substrate, quartz glass substrate or the like.

The anode layer 2 is also called a hole- injecting electrode layer, and that composed of a material having a work function as high as, for example, at least 4 eV is preferably used. In the present invention, the "work function" means the magnitude of minimum work required to take out an electron from a solid into a vacuum.

As the anode layer 2, may be used, for example, an ITO (indium tin oxide) film, tin oxide ($SnO_2$) film, copper oxide (CuO) film or zinc oxide (ZnO) film.

The hole-transporting layer 3, which is also called a hole-injecting layer is provided for the purpose of efficiently

supplying a hole to the luminescent layer 5 and adapted to receive the hole from the anode layer 2 and transport it to the luminescent layer 5 through the copper phthalocyanine layer 4.

As a material for forming the hole-transporting layer 3, may be used an aromatic polymer, preferably PEDOT (poly(3,4)-ethylenedioxythiophene-polystyrenesulfonate). Besides, 1,1-bis(4-di-p-aminophenyl)cyclohexane, a triphenylamine derivative, carbazole derivative or the like may also be used as the hole-transporting layer 3.

The copper phthalocyanine layer 4, i.e., a layer composed of CuPC is provided between the hole-transporting layer 3 and the luminescent layer 5, whereby an energy barrier between the hole-transporting layer 3 and the luminescent layer 5 can be reduced. The injection of the hole into the luminescent layer 5 can thereby be smoothly conducted, so that energy matching between the hole-transporting layer 3 and the luminescent layer 5 can be easily taken.

Accordingly, an organic EL device having such a copper phthalocyanine layer 4 comes to realize a long life and have high luminous efficiency and excellent durability.

The luminescent layer 5 is a layer where an electron is bonded to a hole to emit the bonding energy thereof as light. As a material for forming this luminescent layer 5, may be used a material containing the phosphorescent agent according to the present invention.

Such a luminescent layer 5 can be formed by, for example, applying the luminescent composition according to the present invention to a surface of a substrate, on which the luminescent layer 5 should be formed, and subjecting the applied composition to a heating treatment.

The electron-injecting layer 6 is a layer adapted to receive an electron from the cathode layer 7 and transport it to the luminescent layer 5.

As a material for forming the electron-injecting layer 6, is preferably used a bathophenanthroline material (BPCs). Besides, an anthraquinodimethane derivative, diphenylquinone derivative, oxadiazole derivative, perylenetetracarboxylic acid derivative or the like may also be used.

As the cathode layer 7, may be used that composed of a material having a work function as low as, for example, at most 4 eV.

Specific examples of the material forming the cathode layer 7 include metal films composed of aluminum, calcium, magnesium, lithium or indium and alloy films of these metals.

In the organic EL device of such a structure, when direct current voltage is applied between the anode layer 2 and the cathode layer 7 by the DC power source 10, the luminescent layer 5 emits light through the anode layer 2 and transparent substrate 1.

In particular, since the copper phthalocyanine layer 4 is provided between the hole-transporting layer 3 and the luminescent layer 5 in this organic EL device, the energy barrier between the hole-transporting layer 3 and the luminescent layer 5 is reduced, so that injection of a hole into the luminescent layer is smoothly conducted. Therefore, this organic EL device exhibits high luminous efficiency and excellent durability.

## BRIEF DESCRIPTION OF THE DRAWING

Fig. 1 illustrates the construction of an organic electroluminescence device according to the present invention.

[Description of Characters]

| | |
|---|---|
| 1 | Transparent substrate |
| 2 | Anode layer |
| 3 | Hole-transporting layer |
| 4 | Copper phthalocyanine layer |
| 5 | Luminescent layer |
| 6 | Electron-injecting layer |
| 7 | Cathode layer |
| 10 | DC power source |

## BEST MODE FOR CARRYING OUT THE INVENTION

The embodiments of the present invention will hereinafter be described. However, the present invention is not limited thereby.

<Synthesis Example of 3-Vinylpicolinic Acid>

Hydrogen chloride gas was introduced for 5 hours into a solution composed of 25 g of 3-hydroxypicolinic acid and 500 ml of methanol in a state that the solution was refluxed. After the hydrogen chloride gas was removed by bubbling of nitrogen, methanol was removed under reduced pressure. The thus-obtained methyl 3-hydroxypicolinate hydrochloride was dissolved in water and neutralized with sodium hydrogencarbonate, and solids deposited were separated by filtration and dried, thereby isolating methyl 3-hydroxypicolinate as 20 g of a white solid.

After a solution composed of 20 g of the resultant methyl 3-hydroxypicolinate, 200 g of methylene chloride and 30 g of triethylamine was cooled to 0°C, and 40 g of anhydrous trifluoromethanesulfonic acid were added dropwise to this solution over 15 minutes, the mixture was stirred at room temperature for 3 hours. After the thus-obtained solution was diluted with methylene chloride and washed with water, an organic layer was dried over anhydrous sodium sulfate and then evaporated, thereby obtaining 22 g of methyl 3-trifluoromethanesulfoxypicolinate.

A solution composed of tributylvinyltin, lithium chloride, palladium dichlorobis(triphenylphosphine), 2,6-di-t-butylphenol and dimethylformamide was mixed with 22 g of methyl 3-trifluoromethanesulfoxypicolinate, and the resultant mixture was heated and stirred at 100°C for 3 hours under a nitrogen stream. After this reaction solution was cooled, diluted with hexane and washed with water, an organic layer was dried over anhydrous sodium sulfate, evaporated, purified by chromatography on silica gel and then micro-distilled, thereby obtaining 15 g of methyl 3-vinylpicolinate.

After a solution composed of 15 g of the thus-obtained methyl 3-vinylpicolinate, 200 g of methanol, 10 g of water and 2 g of potassium carbonate was refluxed for 3 hours, neutralized with 0.1N hydrochloric acid and then evaporated, recrystallization from methanol was conducted, thereby obtaining 10 g of 3-vinylpicolinic acid.

<Preparation Example 1 of Picolinic Acid-Containing Polymer>

A flask purged with nitrogen was charged with 2.0 g (0.013 mol) of 3-vinylpicolinic acid, 2.5 g (0.007 mol) of 2-(p-styrylphenyl-5-(p-t-butylphenyl)-1-oxa-3,4-diazole, 4.7 g (0.024 mol) of N-vinylcarbazole, 0.18 g of azobisvaleronitrile and 21 g of dimethylformamide, and the mixture was heated and stirred at 80°C for 5 hours. The resultant reaction solution was poured into 1 liter of methanol to conduct reprecipitation and purification, thereby obtaining white powder.

The thus-obtained reaction product was identified as a copolymer obtained by copolymerizing 3-vinylpicolinic acid, 2-(p-styrylphenyl-5-(p-t-butylphenyl)-1-oxa-3,4-diazole and N-vinylcarbazole at a molar ratio of 3:1.4:5.6 by means of $^1$H-NMR.

The weight average molecular weight of the copolymer thus obtained was determined by means of GPC and found to be 23,000. This copolymer is called "Picolinic Acid-Containing Polymer (1)".

<Preparation Example 1 of Metal Complex>

With 2.9 g (10 mmol) of iridium (III) chloride hydrate were mixed 3.50 g (22.6 mmol) of phenylpyridine and 100 g of hydrous methoxyethanol, and the mixture was heated and stirred at 120°C for 10 hours under a nitrogen stream. The solution thus obtained was cooled, and crystals deposited were separated by filtration and vacuum-dried, thereby obtaining 5.41 g (5.1 mmol) of a chlorobis (2-phenylpyridine) iridium (III) dimmer. This metal complex is called "Metal Complex (1)".

<Preparation Example 2 of Metal Complex>

With 2.9 g (10 mmol) of iridium (III) chloride hydrate were mixed 4.63 g (22.6 mmol) of (2-(2,4-difluoro)phenyl-4-methylpyridine) and 100 g of hydrous methoxyethanol, and the mixture was heated and stirred at 120°C for 10 hours under a nitrogen stream: The solution thus obtained was cooled, and crystals deposited were separated by filtration and vacuum-dried, thereby obtaining a chlorobis(2-(2,4-difluoro)phenyl-4-methylpyridine) iridium (III) dimmer. This metal complex is called "Metal Complex (2)".

<Preparation Example 1 of Phosphorescent Agent>

After a solution composed of 2.0 g of Picolinic Acid-Containing Polymer (1), 0.15 g of Metal Complex (1), 0.5 g of sodium hydrogencarbonate and 50 ml of tetrahydrofuran was refluxed for 6 hours under a nitrogen stream, cooling, reprecipitation with methanol and purification were conducted, thereby obtaining a phosphorescent agent wherein $R^1$ and $R^2$ in the general formula (1) are both hydrogen atoms, Y is a single bond, M is Ir, p is 2, and L is ortho-metallation-coordinated phenylpyridine. This phosphorescent agent is called "Phosphorescent Agent (1)".

A chloroform solution of Phosphorescent Agent (1) thus obtained exhibited a phosphorescence spectrum of green.

<Preparation Example 2 of Phosphorescent Agent>

After a solution composed of 2.0 g of Precursor Polymer (1), 0.3 g of Metal Complex (2), 0.5 g of sodium hydrogencarbonate and 50 ml of tetrahydrofuran was refluxed for 6 hours under a nitrogen stream, cooling, reprecipitation with methanol and purification were conducted, thereby obtaining a phosphorescent agent wherein $R^1$ and $R^2$ in the general formula (1) are both hydrogen atoms, M is Ir, p is 2, and L is ortho-metallation-coordinated 2-(2,4-difluoro) phenyl-4-methylpyridine. This phosphorescent agent is called "Phosphorescent Agent (2)".
A chloroform solution of Phosphorescent Agent (2) thus obtained exhibited a phosphorescence spectrum of blue.
A production process of an organic EL device making use of each of Phosphorescent Agent (1) and Phosphorescent Agent (2) thus obtained as a luminescent material and evaluation results will hereinafter be described.

<Production Example of Organic Electroluminescence Device>

Cyclohexanone was added to each of Phosphorescent Agent (1) and Phosphorescent Agent (2) into a solution, thereby preparing Luminescent Composition (A-1) and Luminescent Composition (A-2) each having a luminescent material concentration of 5 % by weight.
For the sake of comparison, a 5 % by weight cyclohexanone solution of Picolinic Acid-Containing Polymer (1) was prepared. This composition is called "Composition B-1".
A 5 % by weight solution of PEDT (trade name: "Bayer P8000" (product of Bayer Yakuhin, Ltd.)) was then applied on to a 5-cm square glass substrate, on the surface of which an ITO film had been formed. The glass substrate, to which this solution had been applied, was heated at 150°C for 30 minutes, and copper phthalocyanine was further vapor-deposited on this glass substrate.
Each of Luminescent Composition (A-1), Luminescent Composition (A-2) and Composition (B-1) was applied on to the glass substrate, on which copper phthalocyanine had been vapor-deposited, by means of a spin coater. At this time, it was confirmed that each composition had good coating property.
After the application, the applied composition was heated to 120°C over 10 minutes, thereby forming a luminescent layer.
Bathophenanthroline and Cs were vapor-deposited on the thus-formed luminescent layer so as to give a molar ratio of 1:3, thereby forming an electron-injecting layer. An aluminum electrode as a cathode was further laminated by 100 nm on the electron-injecting layer. Thereafter, sealing was conducted with glass, thereby completing Organic EL Device (1), Organic EL Device (2) and Comparative Device (1).
Organic EL Device (1) is an organic EL device equipped with a luminescent layer composed of Luminescent Composition (A-1), Organic EL Device (2) is an organic EL device equipped with a luminescent layer composed of Luminescent Composition (A-2), and Comparative Device (1) is an EL device equipped with a luminescent layer composed of Luminescent Composition (B-1).
Direct current voltage of 7V was applied to each of Organic EL Device (1), Organic EL Device (2) and Comparative Device (1) produced in such a manner by using the ITO film as an anode and the aluminum film as a cathode, thereby emitting light to evaluate it as to luminescence color and luminance.
As a result, Organic EL Device (1) exhibited electroluminescence of green, and Organic EL Device (2) exhibited electroluminescence of blue, and the luminance was 100 to 500 cd/$m^2$.
On the other hand, no luminescence was observed on Comparative Device (1).

## EFFECTS OF THE INVENTION

According to the phosphorescent agent of the present invention, a luminescent layer can be easily formed by a wet method such as an ink-jet method, and organic electroluminescence devices having high luminance can be provided. When such a phosphorescent agent is used to form a luminescent layer of an organic electroluminescence device by a wet method, good coating property and excellent luminance are achieved, and luminescence of a wide range can be achieved.
According to the phosphorescent agent of the present invention, a phosphorescent agent, by which a luminescent layer can be easily formed by a wet method such as an ink-jet method, and an organic electroluminescence device having high luminance can be provided, can be produced.
The luminescent composition according to the present invention can provide an organic electroluminescence device high in both luminance and luminous efficiency because it contains the phosphorescent agent described above.
According to the organic electroluminescence device, which is an applied product of the present invention, excellent luminance and luminous efficiency can be achieved because it has a luminescent layer composed of a material containing the phosphorescent agent described above.

## Claims

1. A phosphorescent agent comprising a structural unit represented by the following general formula (1):

General formula (1)

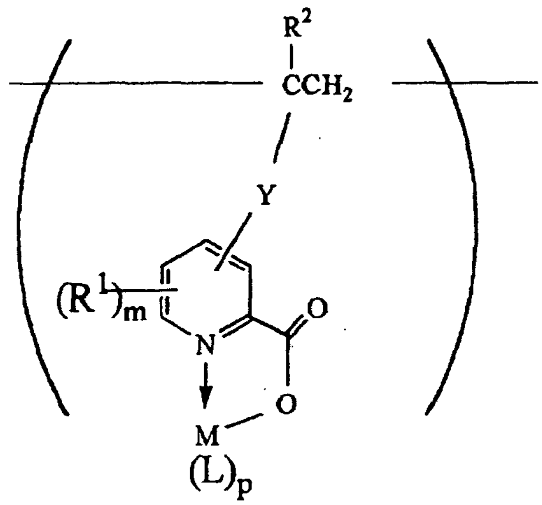

wherein M is a metal atom having a valence of 2 to 4, $R^1$ is a monovalent group selected from a hydrogen atom, halogen atoms, alkyl groups and aryl groups, $R^2$ is a hydrogen atom or methyl group, Y is a single bond or a divalent organic group including a carbonyl group, L is an organic ligand, m is an integer of 1 to 3, and p is an integer of 1 to 4, in its molecule and having a molecular weight of 1,000 to 500,000.

2. The phosphorescent agent according to claim 1, wherein at least one of the structural units represented by the general formula (1) contained in the molecule is such that L indicating the organic ligand in the general formula (1) has an organic ligand represented by the following general formula (2):

General formula (2)

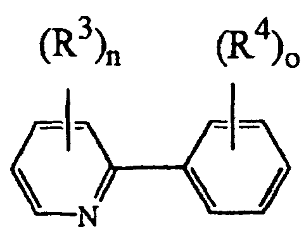

wherein each of $R^3$ and $R^4$ is, independently, a hydrogen atom, halogen atom, alkyl group or aryl group, and each of n and o is, independently, an integer of 1 to 5.

3. The phosphorescent agent according to claim 1 or 2, wherein M indicating the metal atom in the general formula (1) is a metal atom selected from the group consisting of Pd, Pt, Rh, Ir, Ru, Os and Re.

**4.** The phosphorescent agent according to any one of claims 1 to 3, which comprises the structural unit represented by the general formula (1), a structural unit derived from N-vinyl-carbazole and a structural unit derived from vinyl-substituted 1-oxa-3,4-diazole.

**5.** A process for producing the phosphorescent agent according to any one of claims 1 to 4, which comprises reacting a picolinic acid structure-containing polymer with a metal complex.

**6.** The production process of the phosphorescent agent according to claim 5, wherein the metal complex is a metal complex having a metal atom selected from Pd, Pt, Rh, Ir, Ru, Os and Re as a central metal.

**7.** A luminescent composition comprising the phosphorescent agent according to any one of claims 1 to 4 and an organic solvent.

**8.** The luminescent composition according to claim 7, which is suitable for use in an organic electroluminescence device.

**9.** An organic electroluminescence device comprising at least an anode layer, a luminescent layer obtained from a material containing the phosphorescent agent according to any one of claims 1 to 4 and a cathode layer.

**10.** The organic electroluminescence device according to claim 9, which is obtained by laminating the anode layer, a hole-transporting layer, a copper phthalocyanine layer and the luminescent layer in this order.

**11.** The organic electroluminescence device according to claim 9 or 10, which has a luminescent layer composed of the luminescent composition according to claim 7 or 8.

**12.** An organic electroluminescence device obtained through a step of forming a luminescent layer by applying the luminescent composition according to claim 7 or 8 to a surface of a substrate, on which the luminescent layer should be formed, and subjecting the applied composition to a heating treatment.

Fig . 1

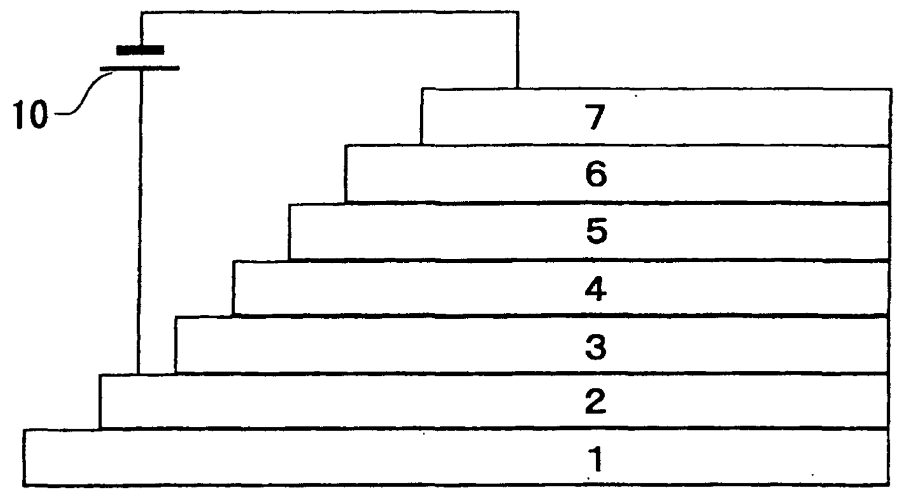

## INTERNATIONAL SEARCH REPORT

International application No.
PCT/JP03/02207

A. CLASSIFICATION OF SUBJECT MATTER
Int.Cl[7] C09K11/06, H05B33/14, C08F8/42

According to International Patent Classification (IPC) or to both national classification and IPC

B. FIELDS SEARCHED

Minimum documentation searched (classification system followed by classification symbols)
Int.Cl[7] C09K11/06, H05B33/14, C08F8/42

Documentation searched other than minimum documentation to the extent that such documents are included in the fields searched

Electronic data base consulted during the international search (name of data base and, where practicable, search terms used)
CA(STN), REGISTRY(STN)

C. DOCUMENTS CONSIDERED TO BE RELEVANT

| Category* | Citation of document, with indication, where appropriate, of the relevant passages | Relevant to claim No. |
|---|---|---|
| Y<br>A | WO 01/041512 A1 (The University of Southern California),<br>07 June, 2001 (07.06.01),<br>& JP 2003-515897 A | 1-3,5-12<br>4 |
| Y<br>A | WO 02/15645 A1 (The Trustees of Princeton University),<br>21 February, 2002 (21.02.02),<br>& AU 2001-083274 A | 1-3,5-12<br>4 |
| Y | US 5529853 A (Sanyo Electric Co., Ltd.),<br>25 June, 1996 (25.06.96),<br>& JP 6-283268 A | 1-3,5-12 |

[X] Further documents are listed in the continuation of Box C. [ ] See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 21 May, 2003 (21.05.03) | 03 June, 2003 (03.06.03) |
| Name and mailing address of the ISA/<br>Japanese Patent Office | Authorized officer |
| Facsimile No. | Telephone No. |

Form PCT/ISA/210 (second sheet) (July 1998)

**INTERNATIONAL SEARCH REPORT**

International application No.
PCT/JP03/02207

C (Continuation). DOCUMENTS CONSIDERED TO BE RELEVANT

| Category* | Citation of document, with indication, where appropriate, of the relevant passages | Relevant to claim No. |
|---|---|---|
| Y | Nobuyuki HIGASHIYAMA, "Effects of Zinc(II) on Fluorescence Properties of Divalent Europium-poly(Methacrylate Containing 15-crown 5 Structure), Complex", Chemistry Letters, 1990, pages 2029 to 2032 | 1-3,5-12 |
| Y | US 2002/0022149 A1 (Teruichi WATANABE), 21 February, 2002 (21.02.02), & JP 2001-313177 A | 10 |

Form PCT/ISA/210 (continuation of second sheet) (July 1998)